# EUROPEAN PATENT SPECIFICATION

(11) **EP 4 270 026 B1**
(45) Date of publication and mention of the grant of the patent: **21.01.2026**
(21) Application number: 23165762.8
(22) Date of filing: 31.03.2023
(51) Int. Cl.: G01R 31/327, H01H 71/04

(54) **SYSTEMS FOR SOURCE IDENTIFICATION OF A FAULT SUCH AS ARC FAULT OR GROUND FAULT EVENT IN A COMMUNICATING PANEL**
SYSTEME ZUR QUELLENIDENTIFIKATION EINES FEHLERS WIE LICHTBOGENFEHLER ODER ERDSCHLUSSEREIGNIS IN EINER KOMMUNIKATIONSTAFEL
SYSTÈMES D'IDENTIFICATION DE SOURCE D'UN DÉFAUT TEL QU'UN DÉFAUT D'ARC OU UN ÉVÉNEMENT DE DÉFAUT À LA TERRE DANS UN PANNEAU DE COMMUNICATION

(30) Priority: 31.03.2022 US 202217657496
(43) Date of publication of application: 01.11.2023
(73) Proprietor: Siemens Industry, Inc., Alpharetta, GA 30005 (US)
(72) Inventor: NAYAK, Amit, Atlanta, 30339 (US); WATFORD, Russell Thomas, Lawrenceville, 30044 (US)
(74) Representative: Isarpatent

(56) References cited:
- WO-A1-2018/018144
- US-A1- 2019 157 021
- US-A1- 2020 052 482
- US-A1- 2020 366 078
- ATOM POWER: "Atom Power invented a new Circuit Breaker", 19 February 2020 (2020-02-19), pages 1 - 20, XP093084339, Retrieved from the Internet <URL:http://5.imimg.com/data5/SELLER/Doc/2022/3/XS/SZ/YO/25884502/solid-state-breaker.pdf> [retrieved on 20230921]

## Description

### BACKGROUND

### 1. Field

Aspects of the present invention generally relate to methods and systems for source identification of a fault such as arc fault or ground fault event in a communicating panel.

### 2. Description of the Related Art

The customer or end user of a residential power distribution system does not have an understanding of the complete layout of their power distribution system panel readily available to help trouble shoot issues or problems which will arise in their home or private dwelling or residence. The end user (homeowner or electrical contractor) is often facing the need to identify a source of such an issue and may not understand the source that caused an event such as a residential circuit breaker tripping or disengaging a load as a result of a fault condition.

In some cases, circuit breakers tripped or loads in a circuit disengaged because of "electronic" noisy loads, arc fault events or ground fault events and/or an overload condition within the same circuit.

There are other cases, when this is not the reason. In these cases for example, an arc fault circuit interrupter (AFCI) or a ground fault circuit interrupter (GFCI) can trip as a result of a load on a separate circuit misbehaving either because of a fault condition or some other reason. In this case, diagnosing the exact nature of the fault or the cause of the fault or the circuit that may have caused the tripping is missed. The homeowner or electrical contractor will spend extra time debugging individual circuits or branches originating from a power distribution system panel to find what caused the tripping event or focus only on the device monitoring the branch that resulted in trip and mis-diagnose the issue.

Although newer AFCI, GFCI, and Dual Function AFCI (DF AFCI) devices today have light emitting diode (LED), which can be energized or controlled through the operations of intelligent hardware through microprocessors or microcontrollers for indications and in some cases, store information such as fault events or waveforms of the load conditions that may identify the fault conditions within the non volatile memory components either as stand alone components or integrated within the microprocessors or microcontrollers even though the end users are not be aware of the conditions that caused the circuit breaker to trip or disengage the loads connected to specific branches.

In absence of real accurate methods of identifying the exact nature of the fault, end user (homeowner or electrical contractor) conduct their evaluation on individual circuits one by one to rule out the nature of the fault before identifying the potential root causes. Since this evaluation is based on experience and pre-existing norms of wiring standards, there are prone to human error present in the identification. Further the increased introduction of significant electronic noise generating smart devices can sometimes interfere with the functionality of an electronic circuit breaker and further cause trouble for the end user to correctly identify the root cause of the fault events.

Therefore, there is a need for a better branch or panel fault analysis system or method.

US 2020/052482 A1 discloses communication enabled circuit breakers and methods associated with such communication enabled circuit breakers. The communication enabled circuit breakers may include one or more current sensors. The one or more current sensors may be disposed in a clip. The clip may be coupled to a line side phase connection, and the clip may be shielded to attenuate signals. US 2020/366078 A1 discloses a circuit breaker includes an electromechanical switch, a current sensor, a voltage sensor, and a processor. The electromechanical switch is serially connected between a line input terminal and a load output terminal of the circuit breaker, and configured to be placed in a switched-closed state or a switched-open state. WO 2018/018144 A1 discloses an electrical receptacle contains contacts, at least one contact for electrical connection to a hot power line and at least one contact for a neutral power line, a controlled switch, such as a TRIAC, is connected in series relationship between the contact and the hot power line, and one or more sensors are provided which detect signals of the hot power line and/or the neutral power line, and the processor provides activation or deactivation control to controlled switch in response to the detected signals that are indicative of conditions relative to the first and second contacts. US 2019/157021 A1 discloses a dynamically coordinatable electrical distribution system includes a plurality of intelligently-controlled protection devices, a communication and control bus (comm/control) bus, and a central computer.

### SUMMARY

Briefly described, aspects of the present invention relate to a branch or a panel fault analysis system or method for source identification of a fault such as arc fault or ground fault event in a Communicating Panel. There is a need for an AFCI/GFCI circuit breaker to include a means to identify the source of the fault that resulted in a breaker trip event. There is a need for the adjacent AFCI/GFCI breakers to record the relative proximity to the faulty circuit, record the fault condition and relay this information to a remote device easily accessible by the end user. With the advent of cellular mobile devices (cell phones or tablets with a wireless connection) and the usage of cellular mobile devices in daily life, it is assumed that this information can be relayed seamlessly to a cellular mobile device of the end user.

This invention intends to resolve the technical difficulty of understanding relative positioning of each electronic circuit breaker. It also incorporates AFCI/GFCI circuit breakers with the means to identify the surrounding circuits and locations within a residential power distribution system or a panel and to continuously monitor the status of each electronic circuit breaker.

Once all the electronic circuit breaker have been installed successfully in a panel, each circuit breaker is able to communicate with its neighboring electronic circuit breaker and transfer this "mesh" information to a remote display device. This process is also described in another words as following the installed breaker when turned ON or powered by turning the handle to an ON position, complete their installation process and during this installation process, the electronic circuit breakers are able to establish a wireless communication, conduct a self-diagnostics to establish operation and complete a commissioning phase. In the commissioning phase, the electronic circuit breakers conduct a self-discovery of surrounding electronic circuit breakers, thereby confirming their proximity and spatial presence with surrounding breakers. After the self-discovery is complete, the "panel" of electronic circuit breakers sends notification and uploads via a user interface that breaker(s) are working properly to a registered cellular mobile device of the end user. For example, the electronic circuit breaker shall be able to identify its own location and the location of its nearest neighbors using a proximity sensor or some other equivalent means. The invention is defined by a branch fault analysis system according to claim 1 and a panel fault analysis system according to claim 10. Further aspects are defined by the corresponding dependent claims.

### BRIEF DESCRIPTION OF THE DRAWINGS

FIG. 1 illustrates a branch fault analysis system in accordance with an exemplary embodiment of the present invention.
FIG. 2 illustrates a panel fault analysis system in accordance with an alternate embodiment of the present invention.
FIG. 3 illustrates a breaker position identifier as breaker 1 in top left in accordance with an exemplary embodiment of the present invention.
FIG. 4 illustrates electrical fault detection (circuit breaker) housing with panel and load connections on either side in accordance with an exemplary embodiment of the present invention.
FIG. 5 illustrates electrical fault detection (circuit breaker) housing with an external input position identifier in accordance with an exemplary embodiment of the present invention.
FIG. 6 illustrates electrical fault detection (circuit breaker) housing with a user input position identifier in accordance with an exemplary embodiment of the present invention.
FIG. 7 illustrates installed and commissioned circuit breakers after self-co-discovery send a notification to a mobile device in accordance with an exemplary embodiment of the present invention.
FIG. 8 illustrates a residential power distribution system view comprising of commissioned and installed circuit breakers with relative spatial proximity in accordance with an exemplary embodiment of the present invention.
FIG. 9 illustrates individual circuit breaker information in accordance with an exemplary embodiment of the present invention.
FIG. 10 illustrates an example scenario of load condition monitoring by companion circuit breakers in accordance with an exemplary embodiment of the present invention.
FIG. 11 illustrates an example of incorrect tripping as shown in companion circuit breakers in accordance with an exemplary embodiment of the present invention.
FIG. 12 illustrates RF noise for easy discerning of possible fault conditions in accordance with an exemplary embodiment of the present invention.
FIG. 13 illustrates an example of incorrect tripping diagnosed correctly using companion communicating circuit breakers in accordance with an exemplary embodiment of the present invention.
FIG. 14 illustrates operation on a circuit breaker trip event - an individual communicating breaker in accordance with an exemplary embodiment of the present invention.
FIG. 15 illustrates an individual circuit breaker communicating with alerts and messages in a Home Area Network in accordance with an exemplary embodiment of the present invention.
FIG. 16 illustrates operation on a circuit breaker trip event - a main controlling unit communicating to each circuit breaker in accordance with an exemplary embodiment of the present invention.
FIG. 17 illustrates a main controlling unit communicating with alerts and messages in the Home Area Network in accordance with an exemplary embodiment of the present invention.

### DETAILED DESCRIPTION

To facilitate an understanding of embodiments, principles, and features of the present invention, they are explained hereinafter with reference to implementation in illustrative embodiments. In particular, they are described in the context of a branch or a panel fault analysis system for source identification of a fault such as an arc fault or a ground fault event in a Communicating Panel. Embodiments of the present invention, however, are not limited to use in the described devices.

The components and materials described hereinafter as making up the various embodiments are intended to be illustrative and not restrictive. Many suitable components and materials that would perform the same or a similar function as the materials described herein are intended to be embraced within the scope of embodiments of the present invention.

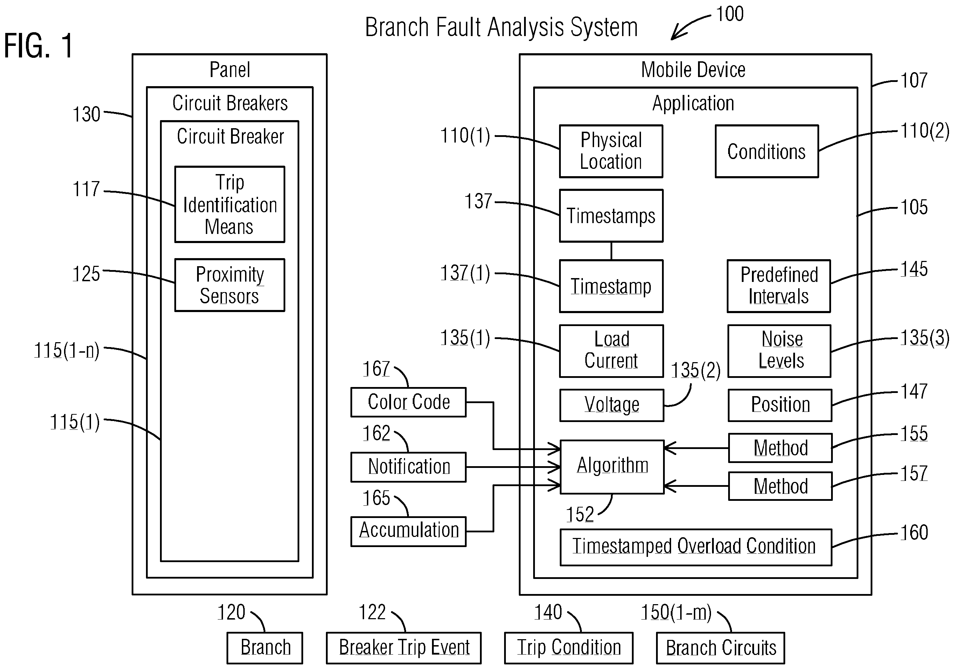

These and other embodiments of the fault analysis system according to the present disclosure are described below with reference to FIGs. 1-17 herein. Like reference numerals used in the drawings identify similar or identical elements throughout the several views. The drawings are not necessarily drawn to scale.

Consistent with one embodiment of the present invention, FIG. 1 represents a branch fault analysis system 100 in accordance with an exemplary embodiment of the present invention. The branch fault analysis system 100 comprises an application 105 running on a mobile device 107 such that it is configured to display a physical location 110(1) and conditions 110(2) experienced by each electronic circuit breaker of a plurality of electronic circuit breakers 115(1-n). The branch fault analysis system 100 further comprises an electronic circuit breaker 115(1) that includes a trip identification means 117 to clearly identify a branch 120 that resulted in a breaker trip event 122, record and relay this information to the mobile device 107 for an end user. The electronic circuit breaker 115(1) further includes one or more proximity sensors 125 to achieve the physical location 110(1) of the electronic circuit breaker 115(1) in a panel 130. A load current 135(1), a voltage 135(2) and noise levels 135(3) are continuously monitored for each electronic circuit breaker of the plurality of electronic circuit breakers 115(1-n) and displayed in the application 105 with time stamps 137. In an event of a trip condition 140, the application 105 is configured to use conditions of the time stamps 137 to highlight the branch 120 that resulted in a trip.

The application 105 running on the mobile device 107 has a time stamp 137(1) that is included with predefined intervals 145 to monitor the voltage 135(2), the load current 135(1) and the noise levels 135(3) and a position 147 for each branch circuit of a plurality of branch circuits 150(1-m). The application 105 further comprises an algorithm 152 that includes a method 155 for comparing the time stamp 137(1) of conditions if a trip occurs and identify a specific electronic circuit breaker 115(1).

The algorithm 152 includes a method 157 wherein a time stamped overload condition 160 is evaluated such that the algorithm 152 identifies the electronic circuit breaker 115(1) with an overload condition that triggered the breaker trip event 122. The algorithm 152 establishes a baseline of the noise levels 135(3) on each functioning branch circuit of the plurality of branch circuits 150(1-m) and compares this value to an acceptable noise level. The algorithm includes a notification 162 of an abnormal condition that exceeds a baseline used to determine a faulty branch 120 that resulted in the trip condition 140. The algorithm includes an accumulation 165 of a noise level of the faulty branch 120 that tripped and upper most noise levels to identify the faulty branch 120 that resulted in the branch trip event 122.

The algorithm 152 includes a color code 167 that represents the noise levels 135(3) and/or overload conditions 160 of each branch circuit of the plurality of branch circuits 150(1-m). A green color represents normal noise levels and overload conditions, a yellow color indicates elevated noise level and overload conditions, and a red color indicates excess noise level and overload conditions. A color code method may be used to identify abnormal conditions in voltage 135(2) and current 135(1) levels.

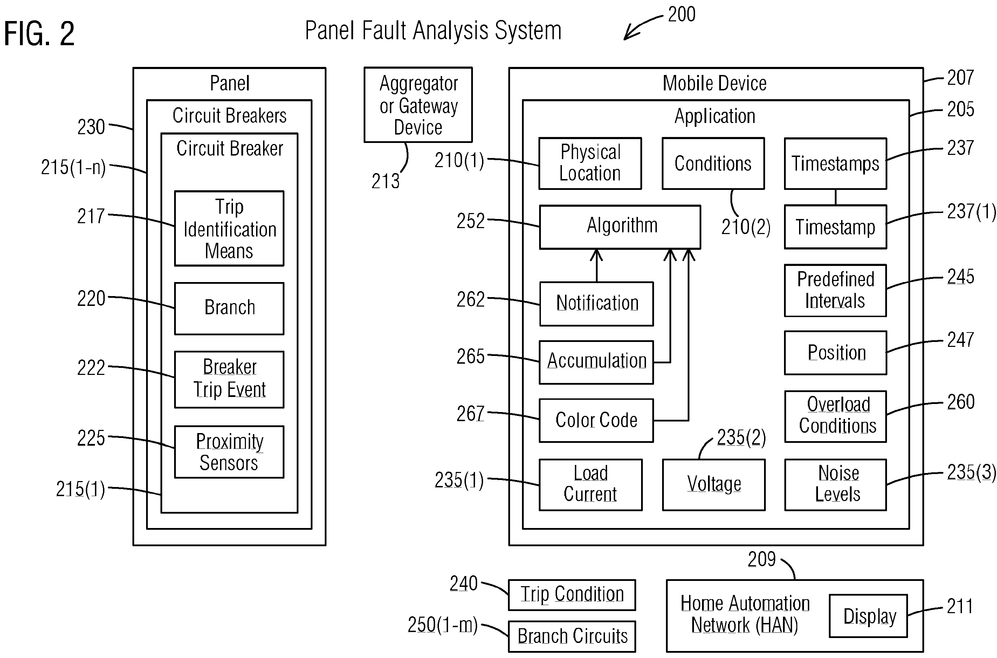

Referring to FIG. 2, it illustrates a panel fault analysis system 200 in accordance with an alternate embodiment of the present invention. The panel fault analysis system 200 comprises a mobile device 207 and/or a home automation network (HAN) 209 with an available display 211. The panel fault analysis system 200 further comprises an aggregator or a gateway device 213 and an application 205 running on the mobile device 207 or the home automation network (HAN) 209. The application 205 is configured to display a physical location 210(1) and conditions 210(2) experienced by each electronic circuit breaker of a plurality of electronic circuit breakers 215(1-n). The application 205 running on the mobile device 207 or the home automation network (HAN) 209 is able to communicate with the aggregator or the gateway device 213 to receive information from all individual breakers of the plurality of electronic circuit breakers 215(1-n).

The panel fault analysis system 200 further comprises an electronic circuit breaker 215(1) that includes a trip identification means 217 to clearly identify a branch 220 that resulted in a breaker trip event 222, record and relay this information to the mobile device 207 and or the home automation network (HAN) 209 for an end user through the aggregator or a gateway device 213. The electronic circuit breaker 215(1) monitoring each branch would need to communicate to the aggregator or gateway device 213. The electronic circuit breaker 215(1) further includes one or more proximity sensors 225 to achieve the physical location 210(1) of the electronic circuit breaker 215(1) in a panel 230. A load current 235(1), a voltage 235(2) and noise levels 235(3) are continuously monitored for each electronic circuit breaker of the plurality of electronic circuit breakers 215(1-n) and displayed in the application 205 with time stamps 237. In an event of a trip condition 240, the application 205 is configured to use conditions of the time stamps 237 to highlight the branch 220 that resulted in a trip.

The application 205 running on the mobile device 207 or the display 211 which is part of the home automation network (HAN) 209 further comprises an algorithm 252 wherein a time stamp 237(1) is included with predefined intervals 245 to monitor the voltage 235(2), the load current 235(1) and the noise levels 235(3) and a position 247 for each branch circuit of a plurality of branch circuits 250(1-m).

Individual branch time stamp information is communicated to the aggregator or the gateway device 213 for processing and relayed to the mobile device 207 and/or the home automation network (HAN) 209. Individual branch time stamp information of the noise levels 235(3) is communicated to the aggregator or the gateway device 213 for processing and relayed to the mobile device 207 and/or the home automation network (HAN) 209 such that the gateway device 213 identifies the branch 220 with an excessive noise level condition that could trigger a trip event and relay the information to the mobile device 207 and/or the home automation network (HAN) 209. Individual branch time stamp information of overload conditions 260 is communicated to the aggregator or the gateway device 213 for processing and relay information to the mobile device 207 and/or the home automation network (HAN) 209 such that the gateway device 213 identifies the branch 220 with an excessive overload condition that could trigger a trip event and relay the information to the mobile device 207 and/or the home automation network (HAN) 209.

The algorithm 252 of the application 205 running on the mobile device 207 or the display 211 which is part of the home automation network (HAN) 209 establishes a baseline of the noise levels 235(3) and the overload conditions 260 on each functioning branch circuit of a plurality of branch circuits 250(1-m) and compares this value to an acceptable noise level.

The algorithm 252 further includes a notification 262 of an abnormal noise and an abnormal overload condition that exceeds the baseline used to determine a faulty branch 120 that resulted in the trip condition 240. The algorithm 252 further includes an accumulation 265 of a noise level of the faulty branch 220 that tripped and upper most noise levels to identify the faulty branch that resulted in the breaker trip event 222. The algorithm 252 further includes a color code 267 that represents the noise levels 235(3) and the overload conditions 260 of each branch circuit of the plurality of branch circuits 250(1-m). The algorithm 252 includes a green color that represents normal noise levels and overload conditions, a yellow color that indicates elevated noise level and overload conditions, and a red color that indicates excess noise level and overload conditions.

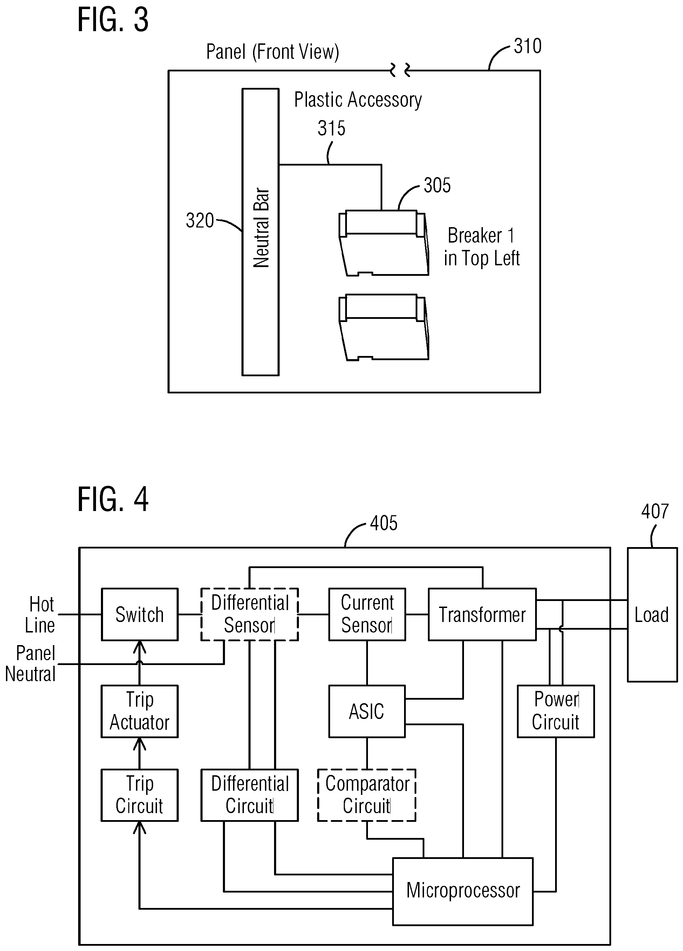

Turning now to FIG. 3, it illustrates a breaker position identifier as electronic circuit breaker #1 305 in top left in accordance with an exemplary embodiment of the present invention. The electronic circuit breaker #1 305 shall be able to identify its own location and the location of its nearest neighbors using a proximity sensor or some other equivalent means.

One embodiment of this spatial and address recognition of the breakers is through slight modification to the way the breaker #1 305 is installed in a residential load panel 310. A panel position identifier can be introduced to the breaker #1 305 so it can self-recognize itself for example as breaker #1 305 on the top left side.

In this embodiment, a plastic accessory 315 as identified in the FIG. 3 could be an additional plastic accessory that may be press fit or attached to a neutral bar 320 and extends to depress a button on an electronic interface in the breaker #1 305 to provide it a position identification. In addition, this plastic accessory 315 may only be present in one location to identify the breaker #1 305 at top left or may be present in two top positions to identify breaker in top position of the panel 310.

FIG. 4 illustrates electrical fault detection (circuit breaker) housing with panel and load connections on either side in accordance with an exemplary embodiment of the present invention. In the U. S. Patent No. 8,929,036 entitled "Arc Fault Circuit Detection Methods, Systems and Apparatus Including Delay" to Nayak et al. an electrical arc fault detection which comprises a housing containing a system with a microprocessor driven design is shown. FIG. 4 shows a housing 405 with connections to a panel (not shown) and a load 407.

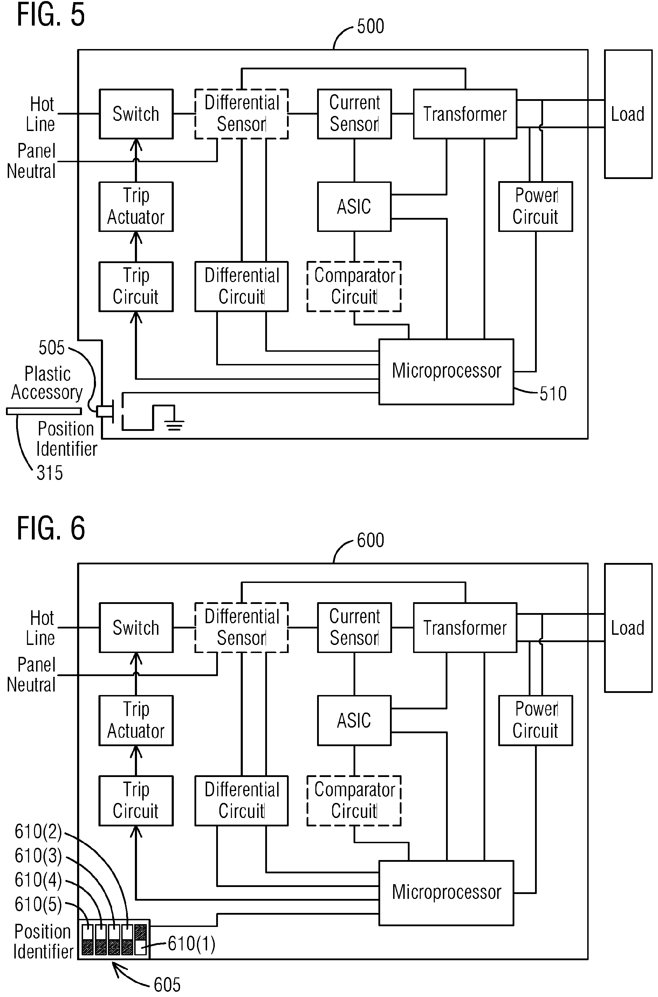

As seen in FIG. 5, it illustrates an electrical fault detection (circuit breaker) housing 500 with an external input position identifier 505 in accordance with an exemplary embodiment of the present invention. In this embodiment the position identification 505 can be considered as a push button which identifies a voltage level for a microprocessor 510 to recognize a current system as the required position. For example, when the position identifier 505 is depressed, a specific general-purpose input/output (GPIO) for the microprocessor 510 may appear a voltage value different compared to when the position identifier 505 is not depressed.

As shown in FIG. 6, it illustrates an electrical fault detection (circuit breaker) housing 600 with a user input position identifier 605 in accordance with another embodiment of the present invention. In this embodiment, the position identifier 605 may be defined by user configurable dip switches 610(1-5) as shown in FIG. 6. In this case, while installing a device in a panel, the user can locate breaker position identification by setting individual switches 610 corresponding to a location position. For example, in this FIG. 6, the position identifier 605 is pointing to a position #1 by selecting a dip switch #1 610(1) to a state 1. The advantage of this method is that there is no need of additional accessory needed in the panel. It does require a user intervention to align with the correct position of the breaker in the panel.

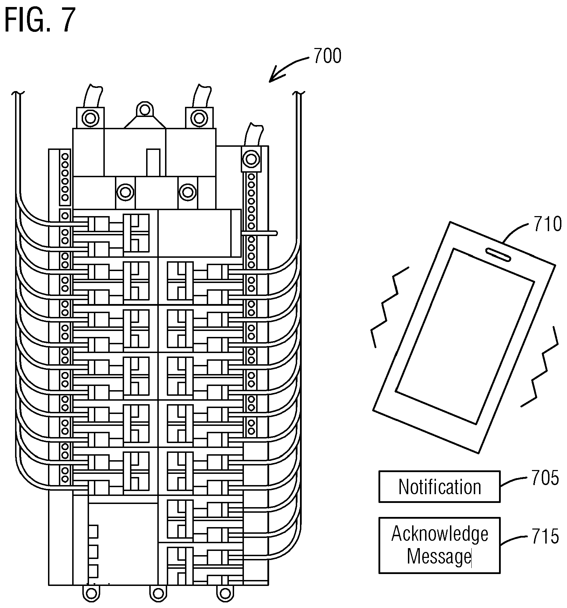

In FIG. 7, it illustrates installed and commissioned circuit breakers 700 after self-co-discovery send a notification 705 to a mobile device 710 in accordance with an exemplary embodiment of the present invention. One embodiment of this nearest neighbor recognition could be transmission of an acknowledgement message 715 from one installed and operational electronic circuit breaker to another and thereby using the signal strength of the message 715 received by an original electronic circuit breaker, it can recognize the spatial positioning of one circuit breaker compared to the other.

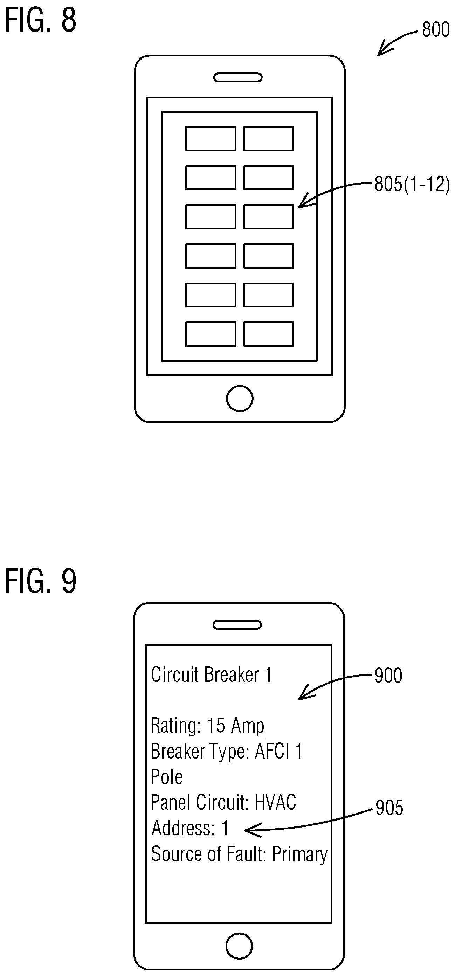

After sending the notification 705 to the mobile device 710 and/or a home information center an end user can through a special application (app) running either on the mobile device 710 or the home information center navigate to a view of a residential power distribution system or a "panel". Such an example is shown in FIG. 8.

With regards to FIG. 8, it illustrates a residential power distribution system 800 view comprising of commissioned and installed circuit breakers 805(1-12) with relative spatial proximity in accordance with an exemplary embodiment of the present invention. Here each electronic circuit breaker 805 may be further identified by a unique name by the user such as a unique specified address within the panel and/or co-recognized by a main load present on a wired branch such as a Washer or a HVAC. A mobile device application (app) as set forth in FIGs. 1-2 could also display among other things for each electronic circuit breaker 805, a rating, a breaker type, a panel circuit, an address, a primary or a secondary source of fault. Such an example is shown in FIG. 9.

With respect to FIG. 9, it illustrates individual circuit breaker information 900 in accordance with an exemplary embodiment of the present invention. A unique specified address 905 could be a part of the traceability code built into a device or as a separate unique number assigned to each AFCI/GFCI circuit breaker and stored within a nonvolatile memory within an electronic circuit breaker during the manufacturing process.

As part of this mobile application (app), each electronic circuit breaker (AFCI/GFCI) shall have the ability to communicate its own current operational status and neighboring devices status within the panel. If the self-diagnostics returns success, the status for the specific location would be stored as OK. If the self-diagnostics returns a failure or if a specific location encounters an arc fault/ground fault/instantaneous fault event, the status/address/location specific information would be sent to all the AFCI/GFCI circuit breakers in the panel along with the type of the event that occurred.

Since the AFCI/GFCI circuit breakers are constantly sending their own and neighboring breaker status to the mobile application (app), this would allow the information to be transmitted with a spatial notation to the end user through the mobile application (app) running on the mobile device 710. This allows an end user the ability to quickly identify the specific breaker that experienced an issue during the operation, from any AFCI/GFCI circuit breaker in the panel as set forth in FIGs. 1-2. The recorded status can be sent to a cellular mobile device running on either iOS or Android environment or to a home central panel through a voice over IP (VoIP) connection or connected to a cloud data service over Internet in a Home automated network (HAN) as set forth in FIGs. 1-2 that can include pop-up graphics to alert or reach the end user's attention.

One example of this alert or alarm message could incorporate a voice activated assistant such as commonly available solutions such as Amazon Alexa or similar when available to be able to inform the user about the concerned alert or alarm.

The U.S. Patent No. 7,864,492 entitled "Systems and Methods for Arc Fault Detection" to Restrepo et al. describes detecting a high frequency component of a sinusoidal electrical power signal also called as received signal strength indication (RSSI) being indicative of the power of the signal content. Monitoring this signal, the electronic circuit breaker can provide indications of the presence of fault like conditions which govern the way the arc fault circuit interrupters provide safety to the downstream loads.

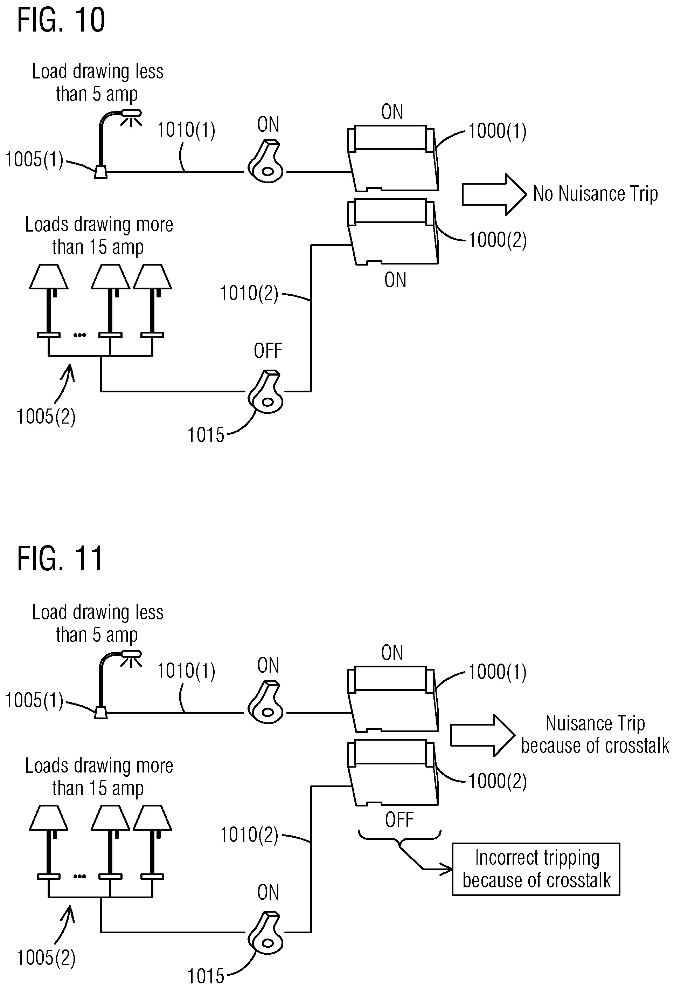

FIG. 10 illustrates an example scenario of load condition monitoring by companion circuit breakers in accordance with an exemplary embodiment of the present invention. In one of the methods described here, FIG. 10 shows companion electronic circuit breakers 1000(1-2) which may occupy neighboring positions in a residential load panel.

In this specific example, one of the circuit breakers 1000(1) is connected to a load 1005(1) consisting of a lamp or a similar load which is drawing a load current less than 5 amperes. For the sake of this example, it is assumed that this first branch 1010(1) is experiencing a fault condition in the wiring and correspondingly generating a RF noise that can be recognized by the electronic circuit breaker 1000(1) as a fault inducing noise. While the load 1005(1) itself is drawing less than 5 Amps, the branch 1010(1) is not required to result in a trip per definition of the safe operation as detailed in UL standard # 1699 also known as UL 1699. In another neighboring second branch 1010(2), a companion breaker 1000(2) is turned on, however, a switch 1015 to enable a load 1005(2) is off resulting in a no active load.

FIG. 11 illustrates an example of incorrect tripping as shown in companion circuit breakers in accordance with an exemplary embodiment of the present invention. Further in this example, as highlighted by FIG. 11, the neighboring branch 1010(2) load 1005(2) is made active for the companion electronic circuit breaker 1000(2). It is feasible that the companion circuit breaker 1000(2), also receives a RF noise radiated across the branch 1010(2) through "cross-talk" and since the load 1005(2) connected to this branch 1010(2) is drawing larger than 5 Amps, the circuit breaker 1000(2) experiences a trip condition per the requirement of safe operation as detailed in UL 1699. If a user or an electrical contractor is investigating this topic, they may mis-diagnose this and concentrate on the second branch 1010(2) while the potential cause of issue is in the first branch 1010(1).

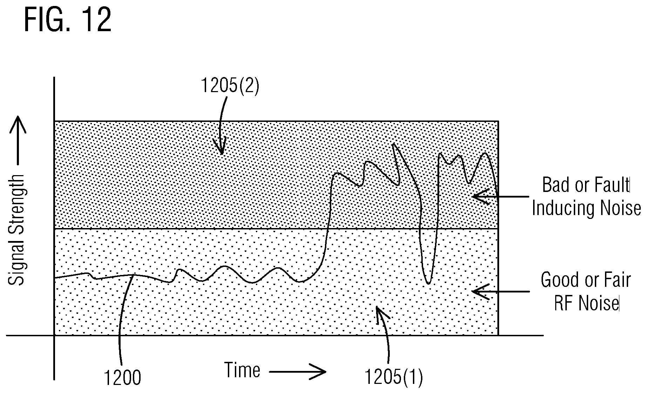

FIG. 12 illustrates a RF noise 1200 for easy discerning of possible fault conditions in accordance with an exemplary embodiment of the present invention. In this example, if the user or the electrical contractor had a way to receive additional diagnostic information confirming the presence of the RF noise 1200 radiated from the first branch 1010(1) to the second branch 1010(2), finding a root cause would have been much easier.

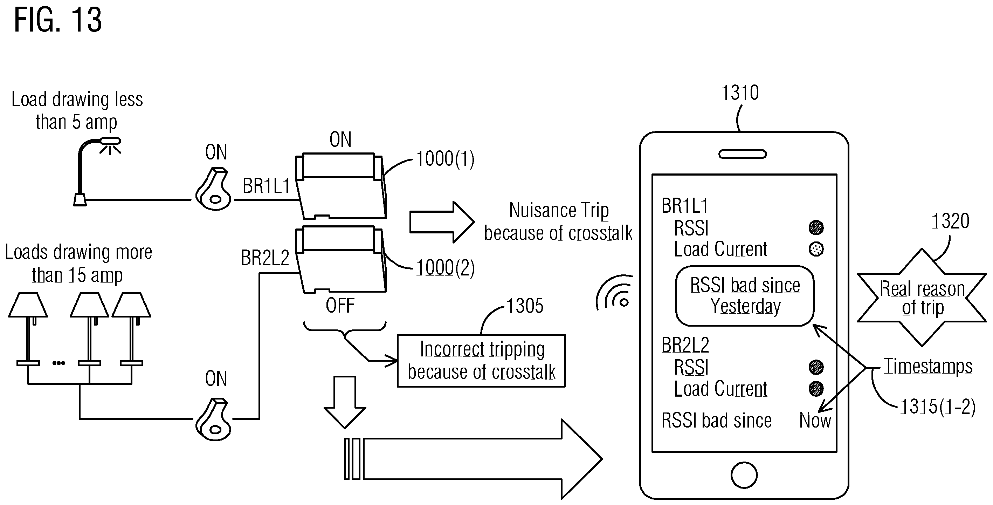

For example, the RF noise 1200 could be categorized as present in a low presence as good or fair RF noise 1205(1) and in a high presence as bad or fault inducing RF noise 1205(2), for example, as shown in FIG. 12. This information along with a timestamp could be transmitted by a respective electronic circuit breaker to a mobile phone or home information center for the homeowner or user to get additional information relative to the identification of the source of the fault location as shown in FIG. 13.

FIG. 13 illustrates an example of incorrect tripping diagnosed correctly using companion communicating circuit breakers 1000(1-2) in accordance with an exemplary embodiment of the present invention. The information "incorrect tripping because of crosstalk" 1305 is sent by the companion communicating circuit breaker 1000(2) to a mobile phone 1310 or a home information center (not shown). The mobile phone 1310 displays two timestamps 1315(1-2). A real reason to trip 1320 is the "RSSI bad since yesterday" timestamp 1315(1).

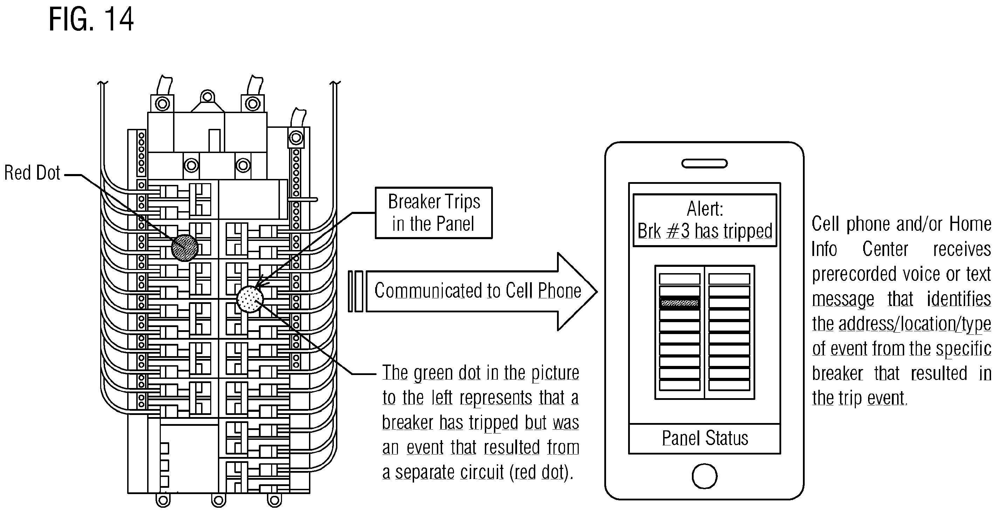

FIG. 14 illustrates operation on a circuit breaker trip event - an individual communicating breaker in accordance with an exemplary embodiment of the present invention. To further describe the above example, in this method, the individual circuit breakers are continuously monitoring the status of each other circuit breaker, the relevant information would be sent to multiple devices within the home/residence and/or to cellular mobile devices (cell phones, tablets with wireless connection). If all the circuit breakers status are OK, the breaker status, locations are recorded and displayed in the media (Application running on the cell phone, tablet etc., home information center in the via VoIP and a cloud data service). In the occurrence of a fault event such as arc fault/ground fault/instantaneous fault, the breaker that tripped is recorded along with the identifying the breaker and location where the fault event was originally started (see FIG. 14)

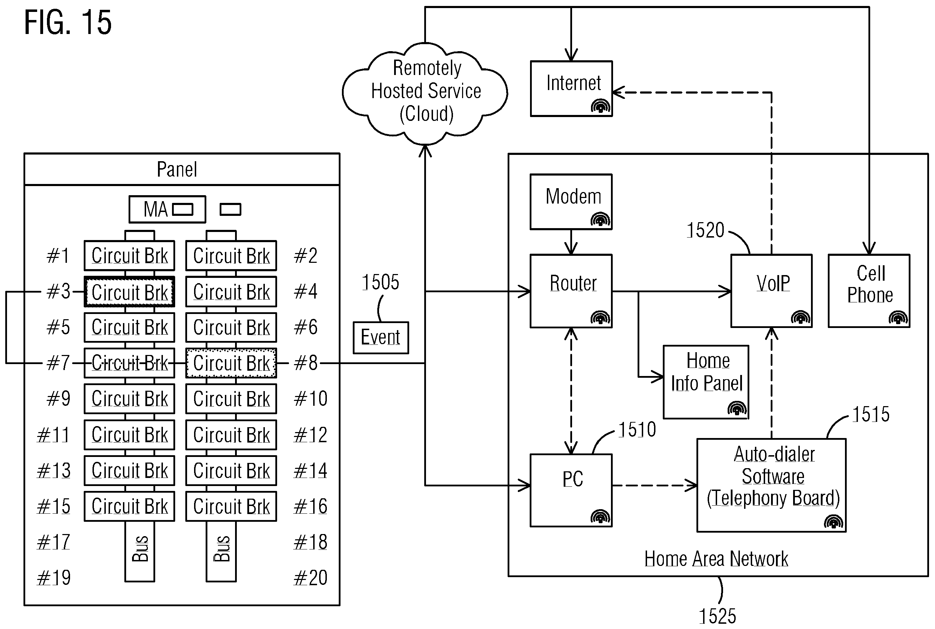

FIG. 15 illustrates an individual circuit breaker communicating with alerts and messages in a Home Area Network 1525 in accordance with an exemplary embodiment of the present invention. In one embodiment, the occurrence of such an event 1505 can also send a signal to a user's PC 1510 connected in a wireless network. The PC 1510 would have an auto dialer software 1515 and connected to a VoIP 1520 on the homeowner's network to send an alert message.

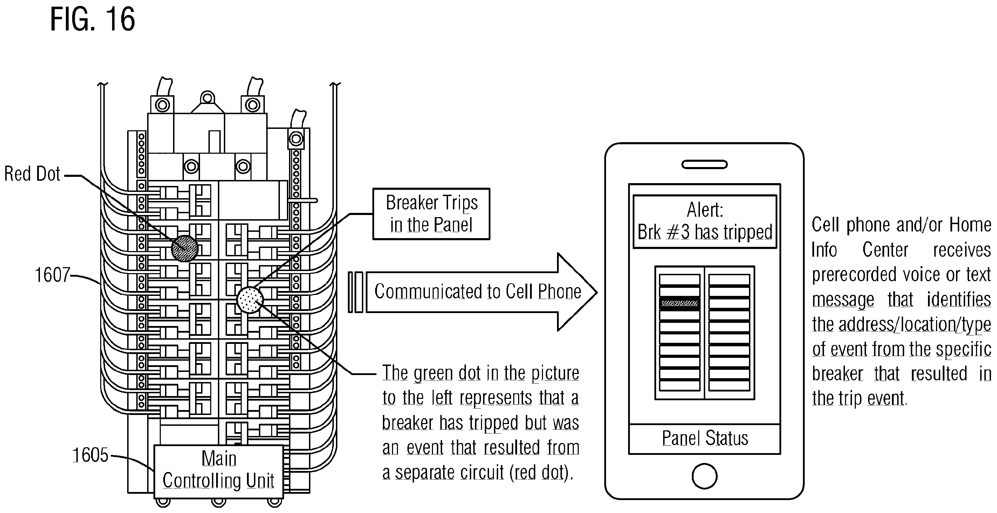

FIG. 16 illustrates operation on a circuit breaker trip event - a main controlling unit communicating to each circuit breaker in accordance with an exemplary embodiment of the present invention. In another embodiment, the source identification of an AFCI/GFCI event may be delegated to a central or main processing or controller unit (a main controlling unit 1605) installed within a panel 1607 acting as an aggregator or a gateway device. In this alternate concept, the main controlling unit 1605 within the panel 1607 performs the operation of identifying the surrounding circuits and circuit breaker's locations within the panel 1607. It continuously monitors the status of each circuit breaker. Each circuit breaker would send information to the main controlling unit 1605 such as its current status and load conditions encountered by it. Among the parameters it may be able to communicate would include how strong arc detection signals are present such as root mean squared load current, root mean square line voltage, average radio frequency (RF) noise content etc.

If these parameters are within the acceptable limits the status would be stored as OK for the specific location or address. If, however, the parameters are outside the acceptable limits or if the electronic circuit breaker has encountered an arc fault/ground fault/instantaneous fault event on a specific circuit, the status/address/location would be sent to the main controlling unit 1605 within the panel 1607 along with the type of the event that occurred. From the main controlling unit 1605, the recorded status can be sent to a cellular mobile device running on iOS or Android environment or a home automation/central panel through a voice over IP (VoIP) connection or via a cloud data service over Internet in a Home Automated Network (HAN) that includes pop-up graphics that alert or reach the end user's attention. This would allow the end user to have an ability to identify a specific circuit breaker that experienced an issue during operation from any electronic circuit breaker within the panel 1607.

In the case of the main controlling unit 1605 monitoring continuously the status of each circuit breaker, the relevant information would be sent to multiple home devices and/or cellular mobile devices. If all the circuit breakers status are OK, the circuit breaker status/locations are recorded and displayed in the media (Application running on the cell phone, tablet etc. and the home information center). In the occurrence of a fault event such as arc fault/ground fault/instantaneous fault, the location of the electronic circuit breaker that tripped is recorded along with identifying the electronic circuit breaker and its location where the fault event was originally started.

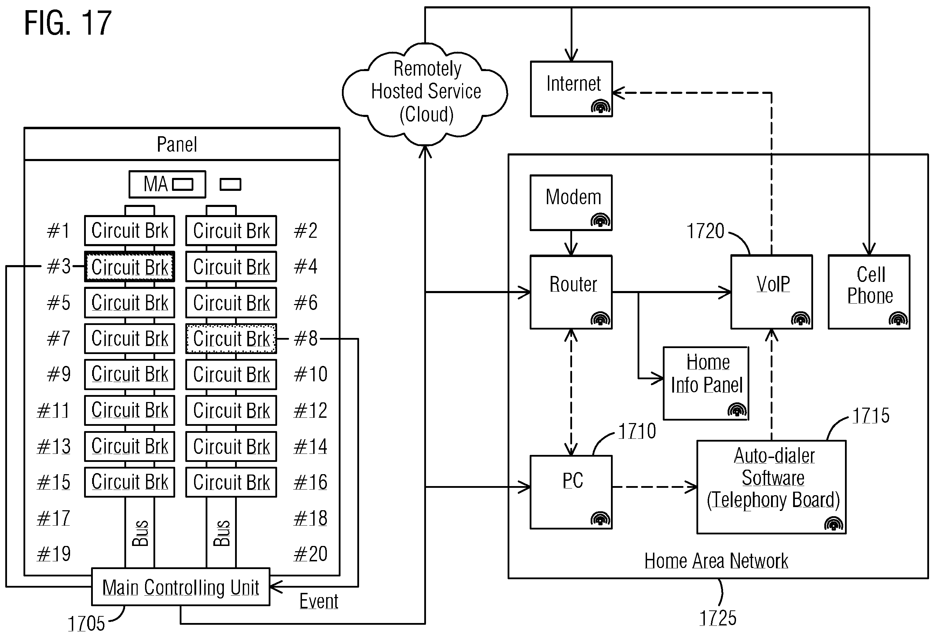

FIG. 17 illustrates a main controlling unit 1705 communicating with alerts and messages in a Home Area Network 1725 in accordance with an exemplary embodiment of the present invention. In one embodiment, the occurrence of such an event can also send a signal to a user's PC 1710 connected in a wireless network. The PC 1710 would have an auto dialer software 1715 and connected to a VoIP 1720 on a homeowner's network to send an alert message.

While a cellular mobile device such as a cell phone or a mobile phone is described here a range of one or more other wireless devices are also contemplated by the present invention. For example, other wireless devices may be implemented based on one or more features presented above without deviating from the spirit of the present invention.

The techniques described herein can be particularly useful for different types of circuit breakers or circuit interrupting devices. While particular embodiments are described in terms of AFCI, GFCI breakers, the techniques described herein are not limited to such circuit breakers but can also be used with other circuit breakers.

While embodiments of the present invention have been disclosed in exemplary forms, it will be apparent to those skilled in the art that many modifications, additions, and deletions can be made therein without departing from the scope of the invention as set forth in the following claims.

## Claims

1. A branch fault analysis system (100) comprising:
an application (105) running on a mobile device (107) is configured to display a physical location (110(1)) and conditions (110(2)) experienced by each electronic circuit breaker of a plurality of electronic circuit breakers (115(1)); and
an electronic circuit breaker (115(1)) including:
trip identification means (117) to clearly identify a branch (120) that resulted in a breaker trip event (122), record and relay this information to the mobile device (107) for an end user, and
wherein the application (105) has a time stamp (137(1)) that is included with predefined intervals (145) to monitor the voltage (135(2)), the load current (135(1)) and the noise levels (135(3)) and a position (147) for each branch circuit of a plurality of branch circuit (150(1-m));
wherein the load current (135(1)), the voltage (135(2)) and noise levels (135(3)) are continuously monitored for each electronic circuit breaker of the plurality of electronic circuit breakers (115(1-n)) and displayed in the application (105) with time stamps (137), and
wherein in an event of a trip condition (140), the application is configured to use conditions of the time stamps (137) to identify the branch (120) that resulted in a trip-;
**characterized in that** the electronic circuit breaker (115(1)) comprises one or more proximity sensors (125) that are configured to identify the own location of the electronic circuit breaker (115(1)) and the location of its nearest neighbors in a panel (130).

2. The system of claim 1, wherein the application (105) running on the mobile device (107) further comprising:
an algorithm (152) of the application (105) wherein the algorithm (152) of the application (105) includes a method (155) for comparing the time stamp (137(1)) of conditions if a trip occurs and identify a specific electronic circuit breaker (115(1)).

3. The system of claim 2, wherein the algorithm (152) of the application (105) includes a method (157) wherein a time stamped overload condition (160) is evaluated such that the algorithm (152) of the application (105) identifies the electronic circuit breaker (115(1)) with an overload condition that triggered the breaker trip event (122).

4. The system of claim 1, wherein the algorithm (152) of the application (105) establishes a baseline of the noise levels (135(3)) on each functioning branch circuit of a plurality of branch circuits (150(1-m)) and compares this value to an acceptable noise level.

5. The system of claim 2, wherein the algorithm (152) of the application (105) includes a notification (162) of an abnormal condition that exceeds a baseline used to determine a faulty branch (120) that resulted in a trip condition (140).

6. The system of claim 5, wherein the algorithm (152)of the application (105) includes an accumulation (165) of a noise level of the faulty branch (120) that tripped and upper most noise levels to identify the faulty branch (120) that resulted in the branch trip event (122).

7. The system of claim 4, wherein the algorithm (152) of the application (105) includes a color code (167) that represents noise level (135(3)) and/or overload conditions (160) of each branch circuit of the plurality of branch circuits (150(1-m)).

8. The system of claim 7, wherein a green color represents normal noise levels and overload conditions, a yellow color indicates elevated noise level and overload conditions, and a red color indicates excess noise level and overload conditions.

9. The system of claim 1, wherein a color code method is used to identify abnormal conditions in voltage (135(2)) and current levels (135(1)).

10. A panel fault analysis system (200) comprising:
a mobile device (207) and/or a home automation network, HAN (209), with an available display (211);
an aggregator or a gateway device (213);
an application (205) running on the mobile device (207) or the HAN (209) is configured to display a physical location (210(1)) and conditions (210(2)) experienced by each electronic circuit breaker of a plurality of electronic circuit breakers (215(1-n)), wherein the application (205) running on the mobile device (207) or the HAN (209) is able to communicate with the aggregator or the gateway device (213) to receive information from all individual breakers of the plurality of electronic circuit breakers (215(1-n)); and
an electronic circuit breaker (215(1)) including:
trip identification means (217) to clearly identify a branch (120) that resulted in a breaker trip event (122), record and relay this information to the mobile device (107) and or the HAN (209) for an end user through the aggregator or a gateway device (213), wherein the electronic circuit breaker monitoring each branch would need to communicate to the aggregator or gateway device (213), and
wherein the application (205) comprises an algorithm (252) wherein a time stamp (237(1)) is included with predefined intervals (245) to monitor the voltage (235(2)), the load current (235(1)) and the noise levels (235(3)) and a position (247) for each branch circuit of a plurality of branch circuits (250(1-m));
wherein the load current (235(1)), the voltage (235(2)) and noise levels (235(3)) are continuously monitored for each electronic circuit breaker of the plurality of electronic circuit breakers (215(1-n)) and displayed in the application (205) with time stamps (237), and
wherein in an event of a trip condition (240), the application is configured to use conditions of the time stamps (237) to identify the branch (220) that resulted in a trip;
**characterized in that** the electronic circuit breaker (215(1)) comprises one or more proximity sensors (225) that are configured to identify the own location of the electronic circuit breaker (215(1)) and the location of its nearest neighbors in a panel (230).

11. The system of claim 10, wherein individual branch time stamp information is communicated to the aggregator or the gateway device (213) for processing and relayed to the mobile device (207) and/or the HAN (209).

12. The system of claim 10, wherein individual branch time stamp information of noise levels (235(3)) is communicated to the aggregator or the gateway device (213) for processing and relayed to the mobile device (207) and/or the HAN (209) such that the gateway device (213) identifies the branch (220) with an excessive noise level condition that could trigger a trip event and relay the information to the mobile device (213) and/or the HAN (209).

13. The system of claim 10, wherein individual branch time stamp information of overload conditions (260) is communicated to the aggregator or the gateway device (213) for processing and relay information to the mobile device (207) and/or the HAN (209) such that the gateway device (213) identifies the branch (220) with an excessive overload condition that could trigger a trip event and relay the information to the mobile device (207) and/or the HAN (209).

## Patentansprüche

1. Zweigfehleranalysesystem (100), das Folgendes umfasst:
eine Anwendung (105), die auf einem Mobilgerät (107) läuft, ist dazu ausgelegt, einen physischen Ort (110(1)) und Bedingungen (110(2)) anzuzeigen, die von jedem elektronischen Leistungsschalter mehrerer elektronischer Leistungsschalter (115(1)) erfahren werden; und
einen elektronischen Leistungsschalter (115(1)), der folgendes beinhaltet:
Auslöseidentifikationsmittel (117) zum eindeutigen Identifizieren einer Verzweigung (120), die zu einem Unterbrecherauslöseereignis (122) führte, Aufzeichnen und Weiterleiten dieser Informationen an das Mobilgerät (107) für einen Endbenutzer, und
wobei die Anwendung (105) einen Zeitstempel (137(1)) aufweist, der mit vordefinierten Intervallen (145) versehen ist, um die Spannung (135(2)), den Laststrom (135(1)) und die Rauschpegel (135(3)) und eine Position (147) für jeden Zweigstromkreis mehrerer Zweigstromkreise (150(1-m)) zu überwachen;
wobei der Laststrom (135(1)), die Spannung (135(2)) und die Rauschpegel (135(3)) kontinuierlich für jeden elektronischen Leistungsschalter der Vielzahl von elektronischen Leistungsschaltern (115(1-n)) überwacht und in der Anwendung (105) mit Zeitstempeln (137) angezeigt werden, und
wobei in einem Fall einer Auslösebedingung (140) die Anwendung dazu ausgelegt ist, Bedingungen der Zeitstempel (137) zu verwenden, um den Zweig (120) zu identifizieren, der zu einer Auslösung führte;
**dadurch gekennzeichnet, dass** der elektronische Leistungsschalter (115(1)) einen oder mehrere Näherungssensoren (125) umfasst, die dazu ausgelegt sind, den eigenen Ort des elektronischen Leistungsschalters (115(1)) und den Ort seiner nächsten Nachbarn in einem Panel (130) zu identifizieren.

2. System nach Anspruch 1, wobei die Anwendung (105), die auf dem Mobilgerät (107) läuft, ferner Folgendes umfasst:
einen Algorithmus (152) der Anwendung (105), wobei der Algorithmus (152) der Anwendung (105) ein Verfahren (155) zum Vergleichen des Zeitstempels (137(1)) von Bedingungen, falls eine Auslösung auftritt, und Identifizieren eines spezifischen elektronischen Leistungsschalters (115(1)) beinhaltet.

3. System nach Anspruch 2, wobei der Algorithmus (152) der Anwendung (105) ein Verfahren (157) beinhaltet, wobei ein zeitgestempelter Überlastzustand (160) so bewertet wird, dass der Algorithmus (152) der Anwendung (105) den elektronischen Leistungsschalter (115(1)) mit einer Überlastungsbedingung identifiziert, der das Unterbrecherauslöseereignis (122) ausgelöst hat.

4. System nach Anspruch 1, wobei der Algorithmus (152) der Anwendung (105) eine Grundlinie der Rauschpegel (135(3)) auf jedem funktionierenden Zweigstromkreis einer Vielzahl von Zweigstromkreisen (150(1-m)) festlegt und diesen Wert mit einem akzeptablen Rauschpegel vergleicht.

5. System nach Anspruch 2, wobei der Algorithmus (152) der Anwendung (105) eine Benachrichtigung (162) über eine anormale Bedingung beinhaltet, die eine Basislinie überschreitet, die verwendet wird, um einen fehlerhaften Zweig (120) zu bestimmen, der zu einer Auslösebedingung (140) führte.

6. System nach Anspruch 5, wobei der Algorithmus (152) der Anwendung (105) eine Akkumulation (165) eines Rauschpegels des fehlerhaften Zweigs (120), der ausgelöst hat, und der obersten Rauschpegel beinhaltet, um den fehlerhaften Zweig (120) zu identifizieren, der zu dem Zweigauslöseereignis (122) führte.

7. System nach Anspruch 4, wobei der Algorithmus (152) der Anwendung (105) einen Farbcode (167) beinhaltet, der Rauschpegel (135(3)) und/oder Überlastungsbedingungen (160) jedes Zweigstromkreises der Vielzahl von Zweigstromkreisen (150(1-m)) repräsentiert.

8. System nach Anspruch 7, wobei eine grüne Farbe normale Rauschpegel und Überlastungsbedingungen repräsentiert, eine gelbe Farbe erhöhte Rauschpegel- und Überlastungsbedingungen angibt und eine rote Farbe übermäßige Rauschpegel- und Überlastungsbedingungen angibt.

9. System nach Anspruch 1, wobei ein Farbcodeverfahren verwendet wird, um anormale Bedingungen in Spannungs- (135(2)) und Strompegeln (135(1)) zu identifizieren.

10. Panelfehleranalysesystem (200), das Folgendes umfasst:
ein Mobilgerät (207) und/oder ein Heimautomatisierungsnetzwerk (HAN) (209) mit einer verfügbaren Anzeige (211);
einen Aggregator oder eine Gateway-Vorrichtung (213);
eine Anwendung (205), die auf dem Mobilgerät (207) oder dem HAN (209) läuft, ist dazu ausgelegt, einen physischen Ort (210(1)) und Bedingungen (210(2)), die von jedem elektronischen Leistungsschalter einer Vielzahl von elektronischen Leistungsschaltern (215(1-n) erfahren werden, anzuzeigen, wobei die Anwendung (205), die auf dem Mobilgerät (207) oder dem HAN (209) läuft, in der Lage ist, mit dem Aggregator oder der Gateway-Vorrichtung (213) zu kommunizieren, um Informationen von allen elektronischen Leistungsschaltern (215(1-n)) zu empfangen; und
einen elektronischen Leistungsschalter (215(1)), der Folgendes beinhaltet:
Auslöseidentifikationsmittel (217) zum eindeutigen Identifizieren eines Zweigs (120), der zu einem Unterbrecherauslöseereignis (122) führte, Aufzeichnen und Weiterleiten dieser Informationen an das Mobilgerät (107) und/oder das HAN (209) für einen Endbenutzer durch den Aggregator oder eine Gateway-Vorrichtung (213), wobei der elektronische Leistungsschalter, der jeden Zweig überwacht, an den Aggregator oder Gateway-Vorrichtung (213) kommunizieren müsste, und
wobei die Anwendung (205) einen Algorithmus (252) umfasst, wobei ein Zeitstempel (237(1)) mit vordefinierten Intervallen (245) versehen ist, um die Spannung (235(2)), den Laststrom (235(1)) und die Rauschpegel (235(3)) und eine Position (247) für jeden Zweigstromkreis einer Vielzahl von Zweigstromkreisen (250(1-m)) zu überwachen;
wobei der Laststrom (235(1)), die Spannung (235(2)) und die Rauschpegel (235(3)) kontinuierlich für jeden elektronischen Leistungsschalter der Vielzahl von elektronischen Leistungsschaltern (215(1-n)) überwacht und in der Anwendung (205) mit Zeitstempeln (237) angezeigt werden, und
wobei in einem Fall einer Auslösebedingung (240) die Anwendung dazu ausgelegt ist, Bedingungen der Zeitstempel (237) zu verwenden, um den Zweig (220) zu identifizieren, der zu einer Auslösung führte;
**dadurch gekennzeichnet, dass** der elektronische Leistungsschalter (215(1)) einen oder mehrere Näherungssensoren (225) umfasst, die dazu ausgelegt sind, den eigenen Ort des elektronischen Leistungsschalters (215(1)) und den Ort seiner nächsten Nachbarn in einem Panel (230) zu identifizieren.

11. System nach Anspruch 10, wobei individuelle Zweigzeitstempelinformationen zum Verarbeiten an den Aggregator oder die Gateway-Vorrichtung (213) kommuniziert und an das Mobilgerät (207) und/oder das HAN (209) weitergeleitet werden.

12. System nach Anspruch 10, wobei individuelle Zweigzeitstempelinformationen von Rauschpegeln (235(3)) zum Verarbeiten an den Aggregator oder die Gateway-Vorrichtung (213) kommuniziert und an das Mobilgerät (207) und/oder das HAN (209) weitergeleitet werden, so dass die Gateway-Vorrichtung (213) den Zweig (220) mit einer übermäßigen Rauschpegelbedingung identifiziert, die ein Auslöseereignis auslösen könnte, und die Informationen an das Mobilgerät (213) und/oder das HAN (209) weiterleitet.

13. System nach Anspruch 10, wobei individuelle Zweigzeitstempelinformationen von Überlastungsbedingungen (260) an den Aggregator oder die Gateway-Vorrichtung (213) zum Verarbeiten und Weiterleiten von Informationen an das Mobilgerät (207) und/oder das HAN (209) kommuniziert werden, so dass die Gateway-Vorrichtung (213) den Zweig (220) mit einem übermäßigen Überlastungszustand identifiziert, der ein Auslöseereignis auslösen könnte, und die Informationen an das Mobilgerät (207) und/oder das HAN (209) weiterleitet.

## Revendications

1. Système d'analyse de défauts de dérivations (100) comprenant :
une application (105) s'exécutant sur un dispositif mobile (107) est configurée pour afficher un emplacement physique (110(1)) et des conditions (110(2)) rencontrées par chaque disjoncteur électronique d'une pluralité de disjoncteurs électroniques (115(1)) ; et
un disjoncteur électronique (115(1)) comportant :
des moyens d'identification de déclenchement (117) permettant d'identifier clairement une dérivation (120) qui a provoqué un événement de déclenchement de disjoncteur (122), d'enregistrer et de relayer ces informations au dispositif mobile (107) pour un utilisateur final, et
dans lequel l'application (105) présente un horodatage (137(1)) qui est inclus avec des intervalles prédéfinis (145) pour surveiller la tension (135(2)), le courant de charge (135(1)) et les niveaux de bruit (135(3)) ainsi qu'une position (147) pour chaque circuit de dérivation d'une pluralité de circuits de dérivation (150(1-m)) ;
dans lequel le courant de charge (135(1)), les niveaux de tension (135(2)) et de bruit (135(3)) sont surveillés en continu pour chaque disjoncteur électronique de la pluralité de disjoncteurs électroniques (115(1-n)) et affichés dans l'application (105) avec des horodatages (137), et
dans lequel en cas de condition de déclenchement (140), l'application est configurée pour utiliser des conditions des horodatages (137) pour identifier la dérivation (120) qui a provoqué un déclenchement ;
**caractérisé en ce que** le disjoncteur électronique (115(1)) comprend un ou plusieurs capteurs de proximité (125) qui sont configurés pour identifier le propre emplacement du disjoncteur électronique (115(1)) et l'emplacement de ses plus proches voisins dans un panneau (130).

2. Système selon la revendication 1, dans lequel l'application (105) s'exécutant sur le dispositif mobile (107) comprend en outre :
un algorithme (152) de l'application (105), l'algorithme (152) de l'application (105) comportant un procédé (155) permettant de comparer l'horodatage (137(1)) de conditions de survenue d'un déclenchement et d'identifier un disjoncteur électronique (115(1)) spécifique.

3. Système selon la revendication 2, dans lequel l'algorithme (152) de l'application (105) comporte un procédé (157) dans lequel une condition de surcharge horodatée (160) est évaluée de telle sorte que l'algorithme (152) de l'application (105) identifie le disjoncteur électronique (115(1)) avec une condition de surcharge qui a déclenché l'événement de déclenchement de disjoncteur (122).

4. Système selon la revendication 1, dans lequel l'algorithme (152) de l'application (105) établit une ligne de base des niveaux de bruit (135(3)) sur chaque circuit de dérivation fonctionnel d'une pluralité de circuits de dérivation (150(1-m)) et compare cette valeur à un niveau de bruit acceptable.

5. Système selon la revendication 2, dans lequel l'algorithme (152) de l'application (105) comporte une notification (162) d'une condition anormale qui dépasse une ligne de base utilisée pour déterminer une dérivation défectueuse (120) qui a provoqué une condition de déclenchement (140).

6. Système selon la revendication 5, dans lequel l'algorithme (152) de l'application (105) comporte une accumulation (165) d'un niveau de bruit de la dérivation défectueuse (120) qui a déclenché et de niveaux de bruit les plus élevés pour identifier la dérivation défectueuse (120) qui a provoqué l'événement de déclenchement de dérivation (122).

7. Système selon la revendication 4, dans lequel l'algorithme (152) de l'application (105) comporte un code couleur (167) qui représente un niveau de bruit (135(3)) et/ou des conditions de surcharge (160) de chaque circuit de dérivation de la pluralité de circuits de dérivation (150(1-m)).

8. Système selon la revendication 7, dans lequel une couleur verte représente des niveaux de bruit normaux et des conditions de surcharge, une couleur jaune indique un niveau de bruit élevé et des conditions de surcharge, et une couleur rouge indique un niveau de bruit excessif et des conditions de surcharge.

9. Système selon la revendication 1, dans lequel un procédé de code couleur est utilisé pour identifier des conditions anormales dans les niveaux de tension (135(2)) et de courant (135(1)).

10. Système d'analyse de défauts de panneau (200) comprenant :
un dispositif mobile (207) et/ou un réseau domotique, HAN (209), avec afficheur (211) disponible ;
un agrégateur ou un dispositif passerelle (213) ;
une application (205) s'exécutant sur le dispositif mobile (207) ou le HAN (209) est configurée pour afficher un emplacement physique (210(1)) et des conditions (210(2)) rencontrées par chaque disjoncteur électronique d'une pluralité de disjoncteurs électroniques (215(1-n)), l'application (205) s'exécutant sur le dispositif mobile (207) ou le HAN (209) pouvant communiquer avec l'agrégateur ou le dispositif passerelle (213) pour recevoir des informations provenant de tous les disjoncteurs individuels de la pluralité de disjoncteurs électroniques (215(1-n)) ; et
un disjoncteur électronique (215(1)) comportant :
des moyens d'identification de déclenchement (217) permettant d'identifier clairement une dérivation (120) qui a provoqué un événement de déclenchement de disjoncteur (122), d'enregistrer et de relayer ces informations au dispositif mobile (107) et/ou au HAN (209) pour un utilisateur final par l'intermédiaire de l'agrégateur ou d'un dispositif passerelle (213), le disjoncteur électronique surveillant chaque dérivation ayant besoin de communiquer avec l'agrégateur ou le dispositif passerelle (213), et
dans lequel l'application (205) comprend un algorithme (252) dans lequel un horodatage (237(1)) est inclus avec des intervalles prédéfinis (245) pour surveiller la tension (235(2)), le courant de charge (235(1)) et les niveaux de bruit (235(3)) ainsi qu'une position (247) pour chaque circuit de dérivation d'une pluralité de circuits de dérivation (250(1-m)) ;
dans lequel le courant de charge (235(1)), les niveaux de tension (235(2)) et de bruit (235(3)) sont surveillés en continu pour chaque disjoncteur électronique de la pluralité de disjoncteurs électroniques (215(1-n)) et affichés dans l'application (205) avec des horodatages (237), et
dans lequel en cas de condition de déclenchement (240), l'application est configurée pour utiliser des conditions des horodatages (237) pour identifier la dérivation (220) qui a provoqué un déclenchement ;
**caractérisé en ce que** le disjoncteur électronique (215(1)) comprend un ou plusieurs capteurs de proximité (225) qui sont configurés pour identifier le propre emplacement du disjoncteur électronique (215(1)) et l'emplacement de ses plus proches voisins dans un panneau (230).

11. Système selon la revendication 10, dans lequel des informations d'horodatage de dérivations individuelles sont communiquées à l'agrégateur ou au dispositif passerelle (213) pour traitement et relayées au dispositif mobile (207) et/ou au HAN (209).

12. Système selon la revendication 10, dans lequel des informations d'horodatage de dérivations individuelles de niveaux de bruit (235(3)) sont communiquées à l'agrégateur ou au dispositif passerelle (213) pour traitement et relayées au dispositif mobile (207) et/ou au HAN (209) de telle sorte que le dispositif passerelle (213) identifie la dérivation (220) avec une condition de niveau de bruit excessif qui pourrait déclencher un événement de déclenchement et relayer les informations au dispositif mobile (213) et/ou au HAN (209).

13. Système selon la revendication 10, dans lequel des informations d'horodatage de dérivations individuelles (260) sont communiquées à l'agrégateur ou au dispositif passerelle (213) pour traiter et relayer des informations au dispositif mobile (207) et/ou au HAN (209) de telle sorte que le dispositif passerelle (213) identifie la dérivation (220) avec une condition de surcharge excessive qui pourrait déclencher un événement de déclenchement et relayer les informations au dispositif mobile (207) et/ou au HAN (209).
